# FASCICULE DE BREVET EUROPEEN

(11) **EP 3 457 002 B1**
(45) Date de publication et mention de la délivrance du brevet: **27.11.2019**
(21) Numéro de dépôt: 18181220.7
(22) Date de dépôt: 02.07.2018
(51) Int. Cl.: F16J 15/06, H01H 9/18, H01H 13/06, G09F 7/00, G09F 7/18

(54) **DISPOSITIF D'ÉTANCHÉITÉ POUR ORGANE DE DIALOGUE HOMME-MACHINE**
DICHTUNGSVORRICHTUNG FÜR MENSCH-MASCHINEN-DIALOGORGAN
SEALING DEVICE FOR MAN-MACHINE DIALOGUE SYSTEM

(30) Priorité: 15.09.2017 FR 1770966
(43) Date de publication de la demande: 20.03.2019
(73) Titulaire: Schneider Electric Industries SAS, 92500 Rueil-Malmaison (FR)
(72) Inventeur: THIZON, Patrice, 16600 Ruelle sur Touvre (FR); RAFFIN, Brice, 16130 Segonzac (FR); DA DALT, Hugues, 16430 CHAMPNIERS (FR)
(74) Mandataire: Dufresne, Thierry

(56) Documents cités:
- FR-A1- 2 583 567
- US-A- 5 313 731
- US-A1- 2012 168 288

## Description

### Domaine technique de l'invention

La présente invention se rapporte à un dispositif d'étanchéité pour organe de dialogue homme-machine et à un ensemble de dialogue homme-machine comprenant ledit organe de dialogue homme-machine et ledit dispositif d'étanchéité. L'ensemble de dialogue homme-machine est également susceptible d'intégrer un dispositif d'identification tel que par exemple un porte-étiquette.

### Etat de la technique

Divers organes de dialogue homme-machine sont connus dans le domaine industriel, sous la forme d'organes de commande et/ou de visualisation.

Dans les organes de commande, on distingue par exemple les boutons poussoirs, les boutons tournants, les boutons tournants à clé ou les boutons d'arrêt d'urgence. Ces différents organes sont destinés à générer une commande dans une installation électrique. Il existe également des organes de visualisation, plus communément appelé voyants lumineux, dont la fonction est simplement de s'allumer pour signaler un état de fonctionnement particulier à l'opérateur.

Un organe de dialogue homme-machine comporte classiquement un corps de forme tubulaire surmonté d'une collerette. Le corps de l'organe de dialogue homme-machine est en matériau plastique ou métallique. Un organe de dialogue homme-machine de ce type est destiné à être fixé à travers une paroi, telle que par exemple la porte d'une armoire électrique. Pour fixer un tel organe dialogue homme-machine, une ouverture d'un diamètre standard est réalisée à travers la paroi. L'organe de dialogue homme-machine est inséré axialement par son corps tubulaire dans ladite ouverture jusqu'à venir en butée par sa collerette contre la paroi, en périphérie de l'ouverture. Il présente ainsi une partie avant visible d'un côté de la paroi et une partie arrière invisible, située de l'autre côté de la paroi. Des moyens de fixation coopérant avec sa partie arrière permettent d'assurer sa fixation à travers l'ouverture.

De manière connue, un joint de forme annulaire est enfilé autour du corps jusqu'à la collerette du bouton et présente notamment une partie destinée à venir en appui contre la périphérie de l'ouverture formée à travers la paroi de manière à assurer l'étanchéité autour de l'ouverture, entre l'avant et l'arrière de la paroi.

FR 2 583 567 A1 divulgue un tel dispositif d'étanchéité, comprenant les caractéristiques du préambule de la revendication 1.

Par ailleurs, il est également connu de monter un dispositif d'identification sur un tel organe de dialogue homme-machine, permettant à un opérateur de rapidement identifier sa fonction. Un tel dispositif est par exemple destiné à porter une étiquette ou toute autre solution d'identification.

Le dispositif d'identification est souvent amovible et doit pouvoir se positionner et s'adapter sur tout organe de dialogue homme-machine. En général, il comporte une ouverture circulaire destinée à être traversée par le corps du bouton et dont la périphérie est prise entre un épaulement formé par la collerette de l'organe de dialogue homme-machine et la paroi. Pour cela, l'organe de dialogue homme-machine comporte un jeu s'étendant entre le bord extérieur de sa collerette et le joint, permettant de venir y glisser le dispositif d'identification. Cependant, lorsque l'organe de dialogue homme-machine est monté sur la paroi en l'absence du dispositif d'identification, le jeu, qui est alors non comblé, devient un lieu de dépôt de particules diverses, notamment de poussières.

L'objectif de l'invention est donc de proposer une solution qui permette de :
- disposer d'un dispositif d'étanchéité agencé directement entre l'organe de dialogue homme-machine et la paroi ;
- positionner un dispositif d'identification tel que défini ci-dessus, sans nécessiter la présence d'un jeu sous la collerette ;
- utiliser le même dispositif d'étanchéité sur l'organe de dialogue homme-machine, que celui-ci soit avec ou sans dispositif d'identification.

Certains organes de dialogue homme-machine connus sont dotés d'une architecture dite affleurante (dite "flush" en anglais) dans laquelle la collerette est d'une hauteur très faible, ne dépassant que très peu du plan formé par la paroi. La solution de l'invention sera notamment parfaitement adaptée pour ce type d'organe de dialogue homme-machine, permettant de conserver cette architecture affleurante tout en remplissant les objectifs définis ci-dessus.

### Exposé de l'invention

La solution de l'invention consiste donc en un dispositif d'étanchéité pour organe de dialogue homme-machine destiné à être fixé à travers une paroi, ledit dispositif comprenant un joint formé en anneau autour d'un axe, ledit joint comprenant :
- Une première partie annulaire comprenant au moins un élément de positionnement du joint agencé pour coopérer avec ledit organe de dialogue homme-machine pour limiter la rotation du joint autour de son axe,
- Une deuxième partie annulaire d'étanchéité comprenant une première face et une deuxième face.

Le dispositif se caractérise en ce que :
- Le joint comporte un premier liseré annulaire formé autour dudit axe en saillie de ladite première face et un deuxième liseré annulaire formé autour dudit axe en saillie de ladite deuxième face,
- Le deuxième liseré suit une trajectoire comportant plusieurs chicanes de manière à former au moins une partie concave délimitant une zone d'appui sur ladite deuxième face et au moins une partie convexe délimitant une zone de dégagement sur ladite deuxième face pour contourner ledit élément de positionnement.

Selon une particularité du dispositif, ladite première partie annulaire se présente sous la forme d'une ceinture et ladite deuxième partie annulaire forme une collerette autour de ladite ceinture.

Selon une autre particularité du dispositif, ladite ceinture comporte une première face interne et une deuxième face externe et ledit élément de positionnement comporte un creux ménagé dans ladite face interne formant une protubérance sur ladite face externe.

Selon une autre particularité du dispositif, le premier liseré comporte au moins une chicane délimitant une zone de dégagement sur ladite première face pour contourner ledit élément de positionnement.

L'invention concerne également un ensemble de dialogue homme-machine, comprenant un organe de dialogue homme-machine doté d'un corps tubulaire surmonté d'une collerette. Cet ensemble se caractérise en ce qu'il comporte un dispositif d'étanchéité tel que défini ci-dessus dans lequel ledit joint est agencé pour ceinturer ledit corps de l'organe de dialogue homme-machine par sa première partie annulaire et pour prendre appui contre la collerette par ledit premier liseré.

Selon une particularité, cet ensemble comporte un dispositif d'identification comprenant au moins une languette agencée pour prendre appui sur ladite zone d'appui de la première face.

Selon une autre particularité de l'ensemble, le dispositif d'identification comporte une première partie présentant une ouverture agencée en périphérie de ladite collerette de l'organe de dialogue homme-machine et une deuxième partie portant ladite au moins une languette.

Selon une autre particularité de l'ensemble, la première partie du dispositif d'identification comporte un logement destiné à recevoir une étiquette d'identification.

Selon une autre particularité de l'ensemble, la première partie comporte un boîtier et la deuxième partie comporte une plaque assemblée sur ledit boîtier.

Selon une autre particularité de l'ensemble, la plaque comporte une ouverture détourée, sur le bord de laquelle est formée ladite au moins une languette.

Selon une autre particularité de l'ensemble, le boîtier et la plaque sont assemblés entre eux par bouterollage ou surmoulage.

### Brève description des figures

D'autres caractéristiques et avantages vont apparaître dans la description détaillée qui suit faite en regard des dessins annexés dans lesquels :
- Les figures 1A à 1C représentent un organe de dialogue homme-machine de type bouton-poussoir sur lequel est adapté le dispositif d'étanchéité de l'invention, respectivement vu de côté, vu en coupe selon A-A, et vu en perspective ;

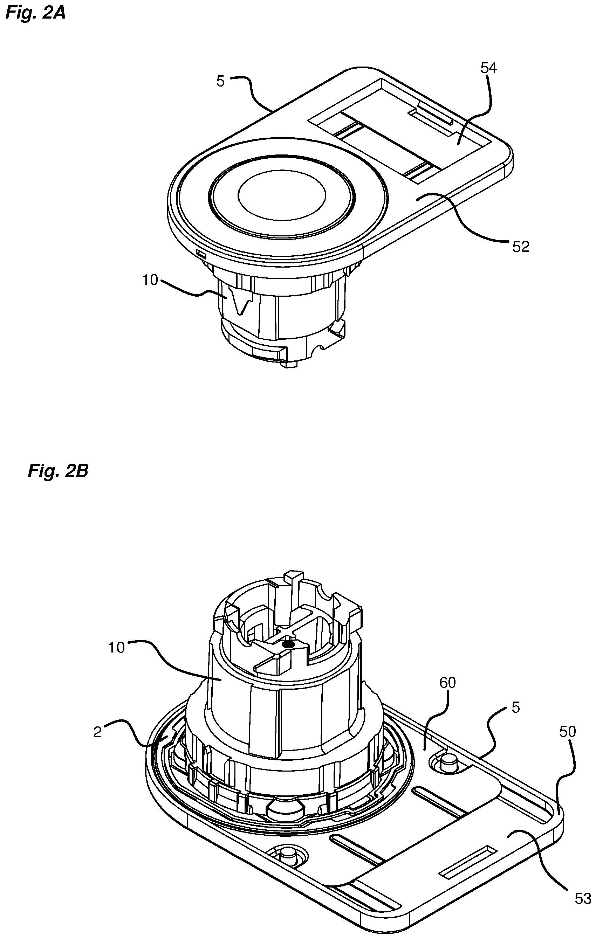

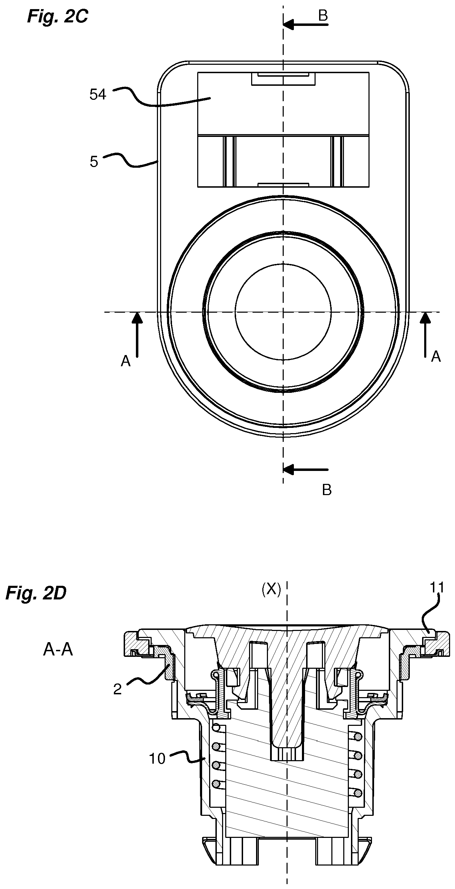

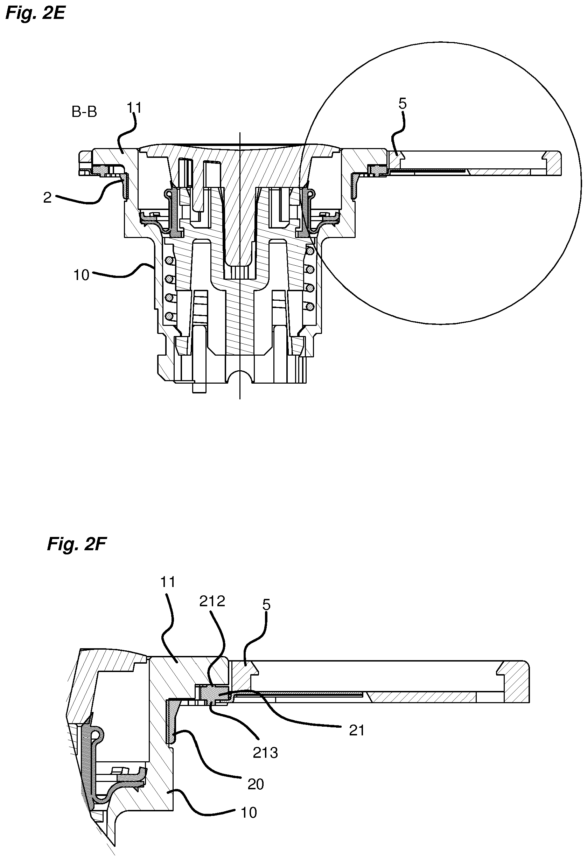

- Les figures 2A à 2F représentent un organe de dialogue homme-machine de type bouton-poussoir sur lequel sont adaptés le dispositif d'étanchéité de l'invention et un dispositif d'identification, respectivement selon une vue en perspective du dessus, une vue en perspective du dessous, une vue de dessus, une vue en coupe selon A-A, une vue en coupe selon B-B, une vue d'un détail de la figure 2E ;
- Les figures 3A à 3C représentent un dispositif d'identification destiné à coopérer avec le dispositif d'étanchéité de l'invention, respectivement selon une vue en perspective et assemblé, une vue en éclaté du dessus, une vue en éclaté du dessous ;
- Les figures 4A à 4F représentent le joint du dispositif d'étanchéité de l'invention, respectivement selon une vue de dessus, une vue de côté, une vue de dessous, une vue en perspective partielle de dessus, une vue en perspective partielle du dessous, une vue en perspective partielle du dessous.

### Description détaillée d'au moins un mode de réalisation

Dans la suite de la description, on définit un axe principal (X).

Les termes supérieur, inférieur, avant et arrière sont à considérer par rapport à cet axe principal (X), représenté sur les figures suivant une direction verticale, cet axe étant perpendiculaire à la paroi P de fixation.

L'invention s'applique à un organe de dialogue homme-machine. Un dispositif d'étanchéité est adapté sur l'organe de dialogue homme-machine, formant un ensemble de dialogue homme-machine. L'ensemble de dialogue homme-machine pourra également comporter un dispositif d'identification.

Par organe de dialogue homme-machine, on entend un organe intégrant une fonction de commande et/ou une fonction de type signalisation lumineuse. De manière non limitative, il pourra ainsi s'agir d'un bouton-poussoir, d'un bouton tournant, d'un bouton d'arrêt d'urgence ou d'un voyant lumineux.

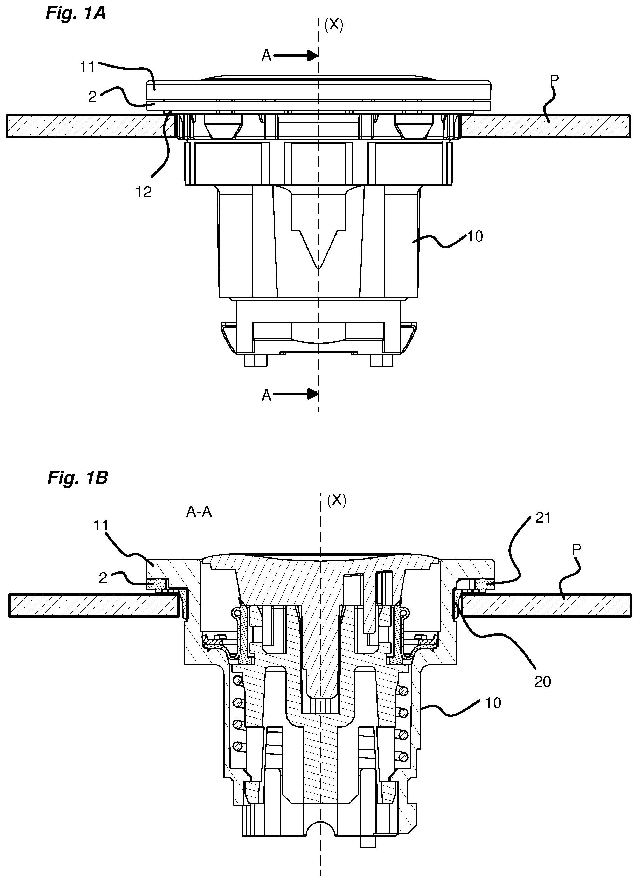

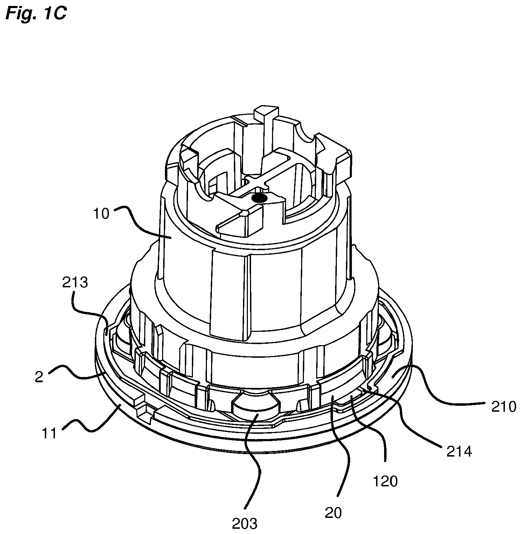

En référence aux figures 1A à 1C, un organe de dialogue homme-machine comporte un corps 10 tubulaire formé suivant l'axe (X) et une collerette 11 surmontant ledit corps 10 tubulaire. Ladite collerette forme ainsi un épaulement 12 s'étendant vers l'extérieur par rapport à la section du corps tubulaire. La collerette 11 peut porter un bouton de commande et/ou un capot transparent pour assurer la signalisation. Le corps tubulaire peut comporter une partie supérieure, située sous la collerette et une partie inférieure, de deux sections de tailles différentes.

L'organe de dialogue homme-machine est destiné à être fixé à travers une paroi P, par exemple la porte d'une armoire électrique. Pour cela, la paroi comporte une ouverture, en général circulaire, d'un diamètre normalisé (par exemple de diamètre normalisé de 22mm). Le corps 10 du bouton est inséré dans l'ouverture jusqu'à sa collerette 11, de sorte que le corps soit situé vers l'arrière de la paroi et la collerette vers l'avant. Sous l'épaulement 12, un dispositif d'étanchéité est positionné pour réaliser l'étanchéité autour de l'ouverture entre l'avant et l'arrière de la paroi.

Le dispositif d'étanchéité comporte un joint 2 formé en anneau et enfilé axialement autour de la partie supérieure du corps du bouton.

De manière classique, le joint 2 sera réalisé dans tout matériau permettant de réaliser le niveau d'étanchéité souhaité, notamment caoutchouc, élastomère ou autre matériau du même type.

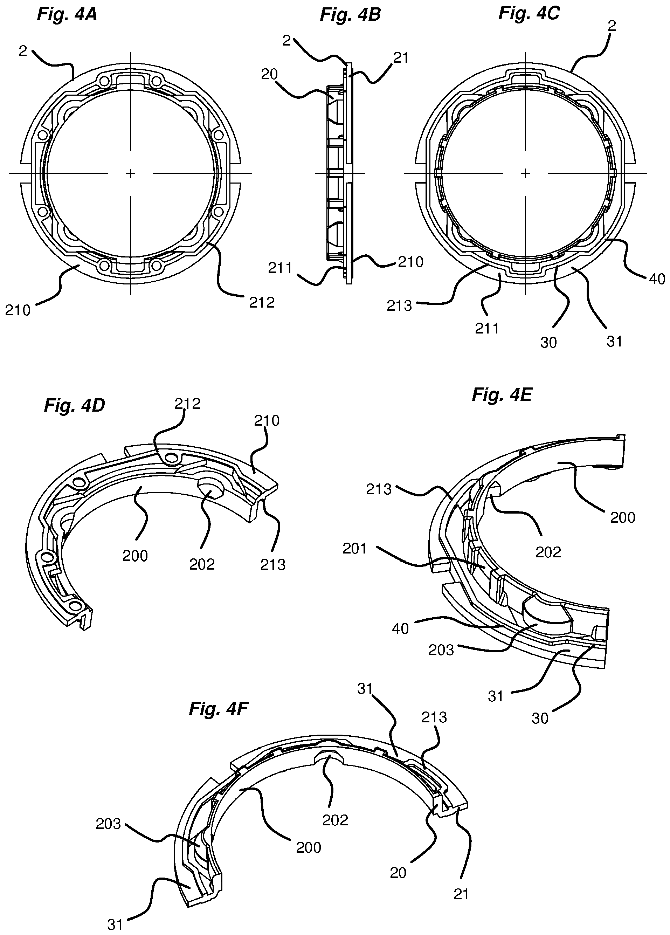

En référence aux figures 4A à 4F, le joint 2 comporte deux parties, une première partie 20 et une deuxième partie 21.

La première partie 20 du joint se présente sous la forme d'une ceinture définissant deux faces opposées, une face interne 200 destinée à être en contact avec le corps de l'organe et une face externe 201 opposée. Cette première partie 20 est destinée à venir ceinturer le corps du bouton.

La deuxième partie 21 du joint est destinée à assurer l'étanchéité autour de l'ouverture formée à travers la paroi. Elle se présente sous la forme d'un anneau plat surmontant la première partie 20 et formant ainsi une collerette. Elle comporte ainsi une première face, dite face supérieure 210, et une deuxième face, dite face inférieure 211.

La deuxième partie 21 comporte également deux liserés, un premier liseré dit liseré supérieur 212 et un deuxième liseré dit liseré inférieur 213. Le liseré supérieur est formé en saillie sur la face supérieure 210 et le liseré inférieur est formé en saillie sur la face inférieure 211.

Le liseré supérieur 212 et le liseré inférieur 213 suivent également une trajectoire annulaire fermée sur leur face respective.

Lors de l'installation, le liseré supérieur 212 est destiné à venir en contact avec l'épaulement 12 formé par la collerette 11 de l'organe de dialogue homme-machine et le liseré inférieur 213 est destiné à venir en contact avec la face avant de la paroi, sur toute la périphérie de l'ouverture (figure 1B).

La première partie 20 du joint 2 comporte un ou plusieurs éléments de positionnement permettant d'assurer des fonctions de positionnement, d'auto-centrage, et d'auto-maintien du joint sur le corps 10 de l'organe de dialogue homme-machine. Chaque élément permet notamment de faire en sorte que le joint soit bien positionné sur l'organe et d'assurer son blocage en rotation autour de l'axe principal (X), après avoir été installé.

Un élément de positionnement peut comporter un creux 202 ou une encoche ménagé sur la face interne 200 de la première partie du joint, formant ainsi une protubérance 203 sur la face externe 201 de cette première partie. Le creux 202 est destiné à coopérer avec un ergot correspondant réalisé sur le corps de l'organe de dialogue homme-machine.

Un autre élément de positionnement peut comporter une découpe 214 réalisée à travers l'anneau plat de la deuxième partie 21 du joint 2 et destinée à coopérer avec un ergot 120 réalisé sur l'épaulement 12 formé par la collerette 11 de l'organe de dialogue homme-machine par rapport au corps 10.

Plusieurs éléments de positionnement de ce type ou de forme équivalente peuvent être réalisés sur le joint. Ils sont destinés à coopérer avec des formes correspondantes réalisées sur l'organe de dialogue homme-machine.

Selon un aspect particulier de l'invention, le liseré inférieur 213 présente une trajectoire qui comporte plusieurs chicanes, de manière à disposer de parties concaves 30 et de parties convexes 40. Chaque partie concave 30 est orientée vers l'intérieur par rapport à l'axe principal et chaque partie convexe 40 est déportée vers l'extérieur par rapport à l'axe principal. Chaque partie concave 30 permet ainsi de délimiter une zone étendue sur la face inférieure 211 de la deuxième partie du joint. Chaque partie convexe 40 est formée de manière à contourner une protubérance 203 d'un élément de positionnement.

La zone délimitée par une partie concave 30 forme une plage d'appui 31 destinée à l'accrochage d'un dispositif d'identification.

Le liseré supérieur 212 peut également comporter plusieurs chicanes de manière à contourner chaque protubérance 203 formée par au moins un élément de positionnement.

Grâce aux chicanes, l'étanchéité est réalisée au plus près du corps de l'organe de dialogue homme-machine autour de l'axe, de manière à concentrer l'étanchéité dans une zone la plus réduite possible, tout en permettant de tenir compte de la configuration particulière du joint.

Les deux liserés 212, 213 peuvent être réalisés l'un au-dessus de l'autre, de manière à suivre une trajectoire identique.

Le joint 2 est réalisé et positionné sur le corps de l'organe de dialogue homme-machine de sorte que le bord extérieur de sa deuxième partie 20 soit à l'aplomb du bord externe de la collerette 11 de l'organe de dialogue homme-machine.

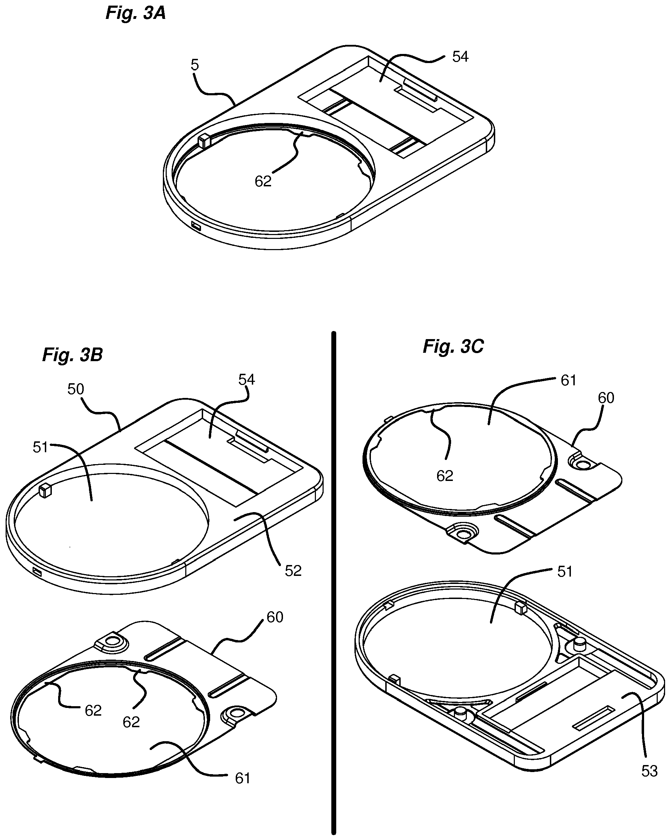

L'ensemble de dialogue homme-machine est également adapté pour comporter un dispositif d'identification 5 tel que représenté sur les figures 3A à 3C. Un tel dispositif d'identification 5 est notamment destiné à identifier l'organe de dialogue homme-machine sur lequel il est adapté.

Selon un aspect de l'invention, le dispositif d'identification 5 comporte un boîtier 50. Le boîtier 50 comporte une ouverture 51 de dimensions suffisantes pour venir épouser la forme externe de la collerette de l'organe de dialogue homme machine. Ce boîtier peut présenter une épaisseur équivalente, voire identique à la hauteur de la collerette de l'organe de dialogue homme-machine.

Le boîtier 50 peut être en matériau plastique.

Le boîtier présente une face avant 52 et une face arrière 53. La face avant peut comporter un logement 54 destiné à recevoir une étiquette d'identification indiquant la fonction de l'organe de dialogue homme-machine associé ou d'autres informations.

Le dispositif d'identification comporte une plaque 60 destinée à être assemblée sur ledit boîtier 50. Cette plaque 60 vient se fixer sur le boîtier, pour recouvrir au moins partiellement la face arrière 53 de celui-ci. L'assemblage peut être réalisée par toute solution connue, par exemple bouterollage ou surmoulage. La plaque 60 peut être en tôle inox emboutie ou matériau et procédé équivalents. La plaque sert de support de fixation au dispositif d'identification.

La plaque 60 comporte également une ouverture 61 détourée de dimensions équivalentes à celle du boîtier 50, cette ouverture 61 venant en vis-à-vis de celle du boîtier du dispositif. La plaque 60 comporte également une ou plusieurs languettes 62 d'accrochage réalisées sur le pourtour de l'ouverture 61, chaque languette 62 s'étendant vers l'intérieur, en direction de l'axe principal (X). Chaque languette 62 est positionnée de manière à venir s'appuyer sur une plage d'appui 31 du joint d'étanchéité. Le dispositif d'identification peut ainsi être fixé par rapport à l'organe de dialogue homme machine par les languettes 62, prises entre la face inférieure 211 de la deuxième partie 21 du joint et la paroi P.

Les languettes 62 peuvent être au nombre de six.

L'épaisseur de chaque languette 62 (suivant l'axe (X)) est inférieure à la hauteur du liseré inférieur 213, ce qui permet de conserver un certain niveau de compression du joint lors du montage.

Un tel dispositif d'identification peut également porter, en complément ou en alternative, des fonctions de signalisation lumineuse mais aussi des fonctions de transmission/réception de données sans fil ou toute autre fonction de ce type. Il pourra notamment intégrer une carte électronique logée dans son boîtier fermé par la plaque.

De manière non limitative, l'ensemble de dialogue homme-machine pourra comporter les dimensions suivantes :
- Epaisseur de la plaque de 0,2 mm ;
- Hauteur du liseré supérieur de 0,15 mm ;
- Hauteur du liseré inférieur de 0,4 mm ;
- Hauteur de la collerette de l'organe de dialogue homme-machine en version affleurante égale à 3 mm.

Lors d'un montage en l'absence du dispositif d'identification, le liseré supérieur 212 et le liseré inférieur 213 sont comprimés jusqu'à une butée mécanique prévue sur l'organe de dialogue homme-machine, cette butée étant positionnée pour fixer la hauteur de l'organe de dialogue homme-machine à l'avant de la paroi à une hauteur donnée (3 mm pour une version affleurante comme sur les figures annexées).

Lors d'un montage en présence d'un dispositif d'identification tel décrit ci-dessus, les languettes 62 viennent s'appuyer contre la face inférieure 211 de la deuxième partie 21 du joint sur les zones d'appuis délimitées grâce aux chicanes. Le liseré supérieur reste comprimé de manière identique mais la compression du liseré inférieur est limitée au niveau des zones d'appui 31 des languettes 62 de la plaque 60 du dispositif d'identification. En dehors de ces zones, la compression du joint peut se poursuivre jusqu'à la butée mécanique prévue sur l'organe de dialogue homme-machine.

Par ailleurs, il faut noter que le liseré supérieur 212 et le liseré inférieur 213 servent notamment à compenser les irrégularités dans la planéité de la face arrière de la paroi P. Ils ont également pour rôle de limiter le couple de serrage nécessaire pour fixer l'organe de dialogue homme-machine sur la paroi P.

On comprend de ce qui précède que la solution de l'invention présente un certain nombre d'avantages, parmi lesquels :
- Une polyvalence de la solution d'étanchéité, celle-ci étant semblable en architecture, avec ou sans dispositif d'identification ;
- Possibilité d'obtenir une forte étanchéité de niveau IP69, même en présence du dispositif d'identification ;
- Une facilité de montage et d'installation ;
- Une solution qui ne nécessite pas la présence d'un jeu entre le joint et la collerette de l'organe de dialogue homme-machine pour fixer le dispositif d'identification, celui-ci étant accroché simplement grâce aux languettes ;
- Une solution d'étanchéité et une solution d'accueil du dispositif d'identification qui n'entraîne pas de surépaisseur, permettant de conserver un encombrement faible en hauteur à l'avant de la paroi et donc de proposer une version affleurante de hauteur limitée (3 mm seulement par exemple).

## Revendications

1. Dispositif d'étanchéité pour organe de dialogue homme-machine destiné à être fixé à travers une paroi, ledit dispositif comprenant un joint (2) formé en anneau autour d'un axe, ledit joint comprenant :
- Une première partie (20) annulaire comprenant au moins un élément de positionnement du joint agencé pour coopérer avec ledit organe de dialogue homme-machine pour limiter la rotation du joint autour de son axe,
- Une deuxième partie (21) annulaire d'étanchéité comprenant une première face (210) et une deuxième face (211),
**Caractérisé en ce que** :
- Le joint comporte un premier liseré (212) annulaire formé autour dudit axe en saillie de ladite première face (210) et un deuxième liseré (213) annulaire formé autour dudit axe en saillie de ladite deuxième face (211),
- Le deuxième liseré (213) suit une trajectoire comportant plusieurs chicanes de manière à former au moins une partie concave (30) délimitant une zone d'appui (31) sur ladite deuxième face et au moins une partie convexe (40) délimitant une zone de dégagement sur ladite deuxième face pour contourner ledit élément de positionnement.

2. Dispositif selon la revendication 1, **caractérisé en ce que** ladite première partie (20) annulaire se présente sous la forme d'une ceinture et **en ce que** ladite deuxième partie (21) annulaire forme une collerette autour de ladite ceinture.

3. Dispositif selon la revendication 2, **caractérisé en ce que** ladite ceinture comporte une première face interne (200) et une deuxième face externe (201) et **en ce que** ledit élément de positionnement comporte un creux (202) ménagé dans ladite face interne (200) formant une protubérance (203) sur ladite face externe.

4. Dispositif selon l'une des revendications 1 à 3, **caractérisé en ce que** le premier liseré (212) comporte au moins une chicane délimitant une zone de dégagement sur ladite première face (210) pour contourner ledit élément de positionnement.

5. Ensemble de dialogue homme-machine, comprenant un organe de dialogue homme-machine doté d'un corps tubulaire (10) surmonté d'une collerette (11), **caractérisé en ce qu'**il comporte un dispositif d'étanchéité tel que défini dans l'une des revendications précédentes dans lequel ledit joint (2) est agencé pour ceinturer ledit corps (10) de l'organe de dialogue homme-machine par sa première partie (20) annulaire et pour prendre appui contre la collerette par ledit premier liseré (212).

6. Ensemble selon la revendication 5, **caractérisé en ce qu'**il comporte un dispositif d'identification (5) comprenant au moins une languette (62) agencée pour prendre appui sur ladite zone d'appui (31) de la première face.

7. Ensemble selon la revendication 6, **caractérisé en ce que** le dispositif d'identification (5) comporte une première partie présentant une ouverture agencée en périphérie de ladite collerette de l'organe de dialogue homme-machine et une deuxième partie portant ladite au moins une languette (62).

8. Ensemble selon la revendication 7, **caractérisé en ce que** la première partie du dispositif d'identification comporte un logement (54) destiné à recevoir une étiquette d'identification.

9. Ensemble selon l'une des revendications 5 à 8, **caractérisé en ce que** la première partie comporte un boîtier (50) et **en ce que** la deuxième partie comporte une plaque (60) assemblée sur ledit boîtier.

10. Ensemble selon la revendication 9, **caractérisé en ce que** la plaque comporte une ouverture détourée, sur le bord de laquelle est formée ladite au moins une languette (62).

11. Ensemble selon la revendication 9 ou 10, **caractérisé en ce que** le boîtier (50) et la plaque (60) sont assemblés entre eux par bouterollage ou surmoulage.

## Patentansprüche

1. Dichtungsvorrichtung für Mensch-Maschine-Dialogorgan, das durch eine Wand hindurch befestigt werden soll, wobei die Vorrichtung eine Dichtung (2) umfasst, die um eine Achse herum als Ring geformt ist, wobei die Dichtung umfasst:
- einen ersten ringförmigen Abschnitt (20), der mindestens ein Platzierungselement für die Dichtung umfasst, das so angeordnet ist, dass es mit dem Mensch-Maschinen-Dialogorgan zusammenwirkt und so die Drehbewegung der Dichtung um ihre Achse einschränkt,
- einen zweiten ringförmigen Dichtungsabschnitt (21), der eine erste Fläche (210) und eine zweite Fläche (211) umfasst,
**dadurch gekennzeichnet, dass**:
- die Dichtung eine erste ringförmige Kante (212), die um die Achse herum aus der ersten Fläche (210) hervorstehend gebildet ist, und eine zweite ringförmige Kante (213) aufweist, die um die Achse herum aus der zweiten Fläche (211) hervorstehend gebildet ist,
- die zweite Kante (213) einen Verlauf mit mehreren Umlenkungen nimmt, damit mindestens ein konkaver Abschnitt (30), der einen Auflagebereich (31) auf der zweiten Fläche begrenzt, und mindestens ein konvexer Abschnitt (40) gebildet wird, der einen Freihaltebereich auf der zweiten Fläche begrenzt und so das Platzierungselement umgeht.

2. Vorrichtung nach Anspruch 1, **dadurch gekennzeichnet, dass** der erste ringförmige Abschnitt (20) in Form einer Umfassung vorliegt und dadurch, dass der zweite ringförmige Abschnitt (21) einen Bund um die Umfassung herum bildet.

3. Vorrichtung nach Anspruch 2, **dadurch gekennzeichnet, dass** die Umfassung eine erste Innenfläche (200) und eine zweite Außenfläche (201) aufweist, und dadurch, dass das Platzierungselement eine Vertiefung (202) aufweist, die in der Innenfläche (200) vorgesehen ist und an der Außenfläche eine Vorwölbung (203) bildet.

4. Vorrichtung nach einem der Ansprüche 1 bis 3, **dadurch gekennzeichnet, dass** die erste Kante (212) mindestens eine Umlenkung aufweist, die einen Freihaltebereich an der ersten Fläche (210) begrenzt und so das Platzierungselement umgeht.

5. Mensch-Maschinen-Dialoganordnung, die ein Mensch-Maschinen-Dialogorgan umfasst, das mit einem röhrenförmigen Körper (10) versehen ist, über dem sich ein Bund (11) befindet, **dadurch gekennzeichnet, dass** sie eine Dichtungsvorrichtung nach einem der vorhergehenden Ansprüche aufweist, wobei die Dichtung (2) so angeordnet ist, dass sie den Körper (10) des Mensch-Maschinen-Dialogorgans mit ihrem ersten ringförmigen Abschnitt (20) umschließt und dass sie mit der ersten Kante (212) an dem Bund anliegt.

6. Anordnung nach Anspruch 5, **dadurch gekennzeichnet, dass** sie eine Kennzeichnungsvorrichtung (5) aufweist, die mindestens eine Lasche (62) umfasst, die so angeordnet ist, dass sie auf dem Auflagebereich (31) der ersten Fläche aufliegt.

7. Anordnung nach Anspruch 6, **dadurch gekennzeichnet, dass** die Kennzeichnungsvorrichtung (5) einen ersten Abschnitt, der eine Öffnung aufweist, die am Umfang des Bunds des Mensch-Maschinen-Dialogorgans angeordnet ist, und einen zweiten Abschnitt aufweist, der die mindestens eine Lasche (62) trägt.

8. Anordnung nach Anspruch 7, **dadurch gekennzeichnet, dass** der erste Abschnitt der Kennzeichnungsvorrichtung eine Aufnahme (54) aufweist, die ein Kennzeichnungsetikett aufnehmen soll.

9. Anordnung nach einem der Ansprüche 5 bis 8, **dadurch gekennzeichnet, dass** der erste Abschnitt ein Gehäuse (50) aufweist, und dadurch, dass der zweite Abschnitt eine an dem Gehäuse montierte Platte (60) aufweist.

10. Anordnung nach Anspruch 9, **dadurch gekennzeichnet, dass** die Platte eine konturierte Öffnung aufweist, an deren Rand die mindestens eine Lasche (62) ausgebildet ist.

11. Anordnung nach Anspruch 9 oder 10, **dadurch gekennzeichnet, dass** das Gehäuse (50) und die Platte (60) mittels Vernieten oder Umspritzen miteinander verbunden sind.

## Claims

1. Sealing device for a human-machine dialogue element intended to be fixed through a wall, said device comprising a seal (2) formed in a ring around an axis, said seal comprising:
- a first annular part (20) comprising at least one positioning element of the seal adapted to cooperate with said human-machine dialogue element to limit the rotation of the seal about its axis,
- a sealing second annular part (21) comprising a first face (210) and a second face (211),
**characterized in that**:
- the seal includes a first annular edge (212) formed around said axis projecting from said first face (210) and a second annular edge (213) formed around said axis projecting from said second face (211),
- the second edge (213) follows a path including a plurality of chicanes so as to form at least one concave part (30) delimiting a bearing zone (31) on said second face and at least one convex part (40) delimiting a disengagement zone on said second face to circumvent said positioning element.

2. Device according to Claim 1, **characterized in that** said first annular part (20) takes the form of a belt and **in that** said second annular part (21) forms a flange around said belt.

3. Device according to Claim 2, **characterized in that** said belt includes an internal first face (200) and an external second face (201) and **in that** said positioning element includes a hollow (202) formed in said internal face (200) forming a protuberance (203) on said external face.

4. Device according to any one of Claims 1 to 3, **characterized in that** the first edge (212) includes at least one chicane delimiting a disengagement zone on said first face (210) to circumvent said positioning element.

5. Human-machine dialogue assembly, comprising a human-machine dialogue element provided with a tubular body (10) surmounted by a flange (11), **characterized in that** it includes a sealing device as defined in any one of the preceding claims in which said seal (2) is adapted to surround said body (10) of the human-machine dialogue element with its first annular part (20) and to bear against the flange through said first edge (212).

6. Assembly according to Claim 5, **characterized in that** it includes an identification device (5) comprising at least one tongue (62) adapted to bear on said bearing zone (31) of the first face.

7. Assembly according to Claim 6, **characterized in that** the identification device (5) includes a first part having an opening arranged at the periphery of said flange of the human-machine dialogue element and a second part carrying said at least one tongue (62).

8. Assembly according to Claim 7, **characterized in that** the first part of the identification device includes a housing (54) intended to receive an identification label.

9. Assembly according to any one of Claims 5 to 8, **characterized in that** the first part includes a casing (50) and **in that** the second part includes a plate (60) assembled onto said casing.

10. Assembly according to Claim 9, **characterized in that** the plate includes a routed opening on the edge of which is formed said at least one tongue (62).

11. Assembly according to Claim 9 or 10, **characterized in that** the casing (50) and the plate (60) are assembled together by peening or overmoulding.
